# EUROPEAN PATENT APPLICATION

(11) **EP 4 354 071 A1**
(43) Date of publication of application: **17.04.2024**
(21) Application number: 22804540.7
(22) Date of filing: 02.05.2022
(51) Int. Cl.: F28F 3/12, F28F 21/06, H05K 7/20

(54) **HEAT EXCHANGER, STRUCTURE, AND METHOD FOR PRODUCING STRUCTURE**

(30) Priority: 18.05.2021 JP 2021083877
(71) Applicant: Resonac Corporation, Tokyo 105-7325 (JP)
(72) Inventor: ITO, Seiichi, Tokyo 100-6606 (JP); YAMASHITA, Takahiro, Tagawa-shi, Fukuoka 825-0005 (JP); SHODA, Hiroaki, Tagawa-shi, Fukuoka 825-0005 (JP); FUKUKAWA, Yuji, Tokyo 100-6606 (JP)
(74) Representative: Hoffmann Eitle
(86) International application number: PCT/JP2022/019536
(87) International publication number: WO 2022/244626

(57) **Abstract**

A heat exchanger includes a hollow outer covering material provided with a heat medium inlet and a heat medium outlet, and includes a first main surface, a second main surface at an opposite side from the first main surface, and a connecting part connecting the first main surface and the second main surface, the first main surface, the second main surface and the connecting part being formed by the outer covering material, wherein the heat exchanger is configured such that a thickness of the heat exchanger is changeable in response to inflow of a heat medium into the outer covering material.

## Description

### Technical Field

The present disclosure relates to a heat exchanger, a structural body, and a method of producing a structural body.

### Background Art

In the fields of electronic devices such as smartphones and personal computers, and battery modules mounted on electric vehicles, hybrid vehicles, and the like, techniques of incorporating water cooling type coolers, heat pipes, and the like as countermeasures against heat generation are known. Also in power modules made of silicon carbide or the like, countermeasures using a cooling plate, a heatsink, and the like have been proposed as countermeasures against heat generation.

As a countermeasure against heat generation in such devices, Patent Literature 1 proposes a heat exchanger produced by resin fusion, the heat exchanger including an inner core material having concave and convex portions inside a bag-shaped outer covering material, and the inner core material and the outer covering material being integrally joined to each other by resin fusion. Patent Literature 1 describes that the heat exchanger is produced by thermally fusing laminate materials having thermal fusion layers, whereby there is no need to use troublesome metal working, the heat exchanger can be produced efficiently and easily, and the cost can be reduced. Patent Literature 1 also describes that the heat exchanger is produced by bonding laminate materials, whereby the heat exchanger has corrosion resistance, and whereby it is possible to achieve sufficient thickness reduction. Patent Literature 1 also describes that, in this heat exchanger, the shape and size of the laminate materials of the outer covering material and the inner core material can be easily changed, whereby the degree of freedom in design can be increased and versatility can be enhanced.

### Citation List

### Patent Literature

Patent Literature 1: Japanese Patent Application Laid-Open (JP-A) No. 2020-3132

### SUMMARY OF INVENTION

### Technical Problem

On the other hand, as the amount of heat generation by heating elements increases, for example, techniques for further improving the heat exchange efficiency is desired. In view of such a circumstance, the present disclosure relates to providing a heat exchanger excellent in heat exchange efficiency, a structural body using the heat exchanger, and a method of producing the structural body.

### Solution to Problem

Means for solving the above problems include the following aspects.
(1) A heat exchanger including a hollow outer covering material provided with a heat medium inlet and a heat medium outlet,
   the heat exchanger including a first main surface, a second main surface at an opposite side from the first main surface, and a connecting part connecting the first main surface and the second main surface, the first main surface, the second main surface and the connecting part being formed by the outer covering material,
   wherein the heat exchanger is configured such that a thickness of the heat exchanger is changeable in response to inflow of a heat medium into the outer covering material.
(2) The heat exchanger according to (1), wherein the outer covering material includes a metal layer and a resin layer provided at an inner side of the metal layer.
(3) The heat exchanger according to (1) or (2), wherein the outer covering material includes a metal layer and a resin layer provided at an outer side of the metal layer.
(4) The heat exchanger according to any one of (1) to (3), wherein the outer covering material includes a metal layer and a resin layer provided at an outer side and an inner side of the metal layer.
(5) The heat exchanger according to any one of (1) to (4), further including an inner core material arranged inside the outer covering material.
(6) The heat exchanger according to (5), wherein the inner core material is fixed to only one of an inner side surface of the first main surface or an inner side surface of the second main surface of the outer covering material, or to neither the inner side surface of the first main surface nor the inner side surface of the second main surface.
(7) A structural body including the heat exchanger according to any one of (1) to (6) and a heat exchange target substance provided at the heat exchanger.
(8) A method of producing a structural body including arranging a heat exchange target substance at the heat exchanger according to any one of (1) to (6).

### Advantageous Effects of Invention

According to the present disclosure, a heat exchanger excellent in heat exchange efficiency, a structural body using the heat exchanger, and a method of producing the structural body are provided.

### BRIEF DESCRIPTION OF DRAWINGS

Fig. 1 is a schematic perspective view of a heat exchanger in one aspect.
Fig. 2 is a cross-sectional view of the heat exchanger in the aspect of Fig. 1 taken along line A-A.
Fig. 3 is a cross-sectional view of a heat exchanger in a modified example of the aspect of Fig. 1.
Fig. 4 is a cross-sectional view of a heat exchanger in a modified example of the aspect of Fig. 1.
Fig. 5 is a schematic perspective view of a converter case to which the heat exchanger in one aspect is applied.
Fig. 6 is a cross-sectional view of the converter case in the aspect of Fig. 5 taken along line X-X.
Fig. 7 is a cross-sectional view of the converter case in the aspect of Fig. 5 taken along line Y-Y.

### DESCRIPTION OF EMBODIMENT

Modes for carrying out embodiments according to the present disclosure will be described below in detail. However, embodiments according to the present disclosure are not limited to the following embodiments. In the following embodiments, components (including elemental steps, etc.) thereof are not essential unless otherwise specified. The same applies to numerical values and ranges, which do not limit the embodiments according to the present disclosure.

In the present disclosure, the term "step" encompasses an independent step separated from other steps as well as a step that is not clearly separated from other steps, as long as a purpose of the step can be achieved.

In the present disclosure, a numerical range specified using "(from) ... to ..." represents a range including the numerical values noted before and after "to" as a minimum value and a maximum value, respectively.

In the numerical ranges described in a stepwise manner in the present disclosure, the upper limit value or the lower limit value described in one numerical range may be replaced with the upper limit value or the lower limit value of another numerical range described in a stepwise manner. Further, in the numerical ranges described in the present disclosure, the upper limit value or the lower limit value of the numerical ranges may be replaced with the values shown in the Examples.

The term "layer" as used herein encompasses, when a region in which the layer is present is observed, not only a case in which the layer is formed over the entire observed region, but also a case in which the layer is formed at only a part of the observed region.

The term "layered" as used herein means disposing layers on one another, in which two or more layers may be bonded with each other, or may be attachable to/detachable from one another.

In the present disclosure, when a thickness is referred to, the thickness means the arithmetic average of the thicknesses measured at randomly-selected 10 points unless otherwise specified.

In a case in which an embodiment is described herein with reference to a drawing, the configuration of the embodiment is not limited by the configuration illustrated in the drawing. The sizes of members in respective drawings are conceptual, and the relative relationships between the sizes of the members are not limited thereto. Further, in the drawings, members having substantially the same function may be denoted by the same reference numeral, and redundant descriptions may be omitted.

### <Heat Exchanger>

A heat exchanger according to the present disclosure includes a hollow outer covering material provided with a heat medium inlet and a heat medium outlet, the heat exchanger including a first main surface, a second main surface at an opposite side from the first main surface, and a connecting part connecting the first main surface and the second main surface, the first main surface, the second main surface and the connecting part being formed by the outer covering material, wherein the heat exchanger is configured such that a thickness of the heat exchanger is changeable in response to inflow of a heat medium into the outer covering material. The heat exchanger according to the present disclosure can improve the heat exchange efficiency of a heat exchange target substance by having this configuration.

The heat exchanger proposed in Patent Literature 1 has various advantages such as thickness reduction and efficient production. In this respect, the inventors have developed a heat exchanger in order to further improve the heat exchange efficiency. In the heat exchanger in Patent Literature 1, the outer covering material and the inner core material therein are fused and integrated with each other. Accordingly, the thickness of the heat exchanger does not change by circulation of a heat medium. On the other hand, the heat exchanger according to the present disclosure is configured such that the thickness is changeable by inflow of a heat medium. Therefore, as a result of circulating a heat medium in the heat exchanger, the outer covering material can be deformed in conformity with the concave and convex portions of a heat exchange target substance provided at the heat exchanger owing to the internal pressure. Accordingly, adhesion between the heat exchanger and the heat exchange target substance can be improved. It is believed that this improves the heat exchange efficiency of the heat exchange target substance.

Hereinafter, an example of the heat exchanger according to the present disclosure will be described with reference to the drawings. Note that embodiments according to the present disclosure are not limited to the aspects illustrated in the drawings.

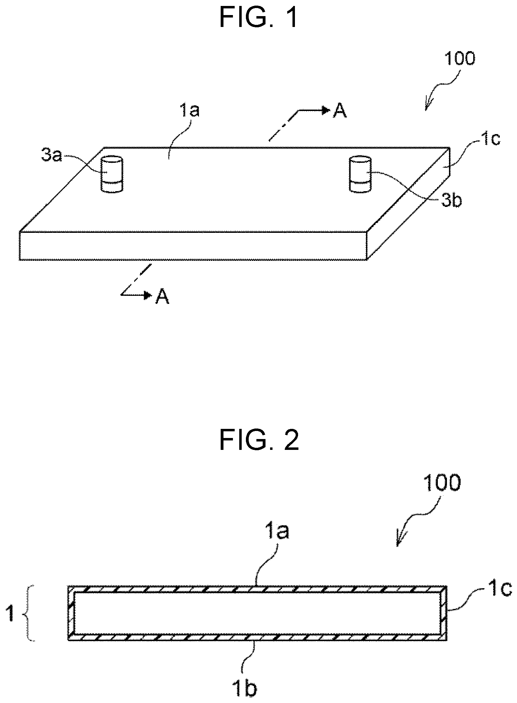

Fig. 1 illustrates a schematic perspective view of a heat exchanger 100, and Fig. 2 illustrates a cross-sectional view taken along line A-A in Fig. 1. The heat exchanger 100 includes a hollow outer covering material 1 provided with a heat medium inlet and a heat medium outlet. The heat exchanger 100 has a first main surface 1a, a second main surface 1b on the opposite side from the first main surface 1a, and a connecting part 1c provided at the peripheral edge portions of the first main surface 1a and the second main surface 1b and connecting the first main surface 1a and the second main surface 1b, whereby the heat exchanger 100 is formed in a hollow shape. The heat medium inlet and the heat medium outlet are provided with joint pipes 3a and 3b, respectively, as illustrated in the drawing, and the heat exchanger 100 is configured such that a heat medium flows into and flows out of the outer covering material 1 through the joint pipes 3a and 3b. By the heat medium flowing in from the heat medium inlet, the internal pressure of the heat exchanger 100 increases, whereby stress that acts to increase the thickness of the heat exchanger 100 is generated, as compared with a case in which a heat medium does not flow in from the heat medium inlet. Therefore, when a heat exchange target substance is provided at the heat exchanger 100, adhesion between the heat exchanger 100 and the heat exchange target substance is improved, and the heat exchange efficiency can be improved.

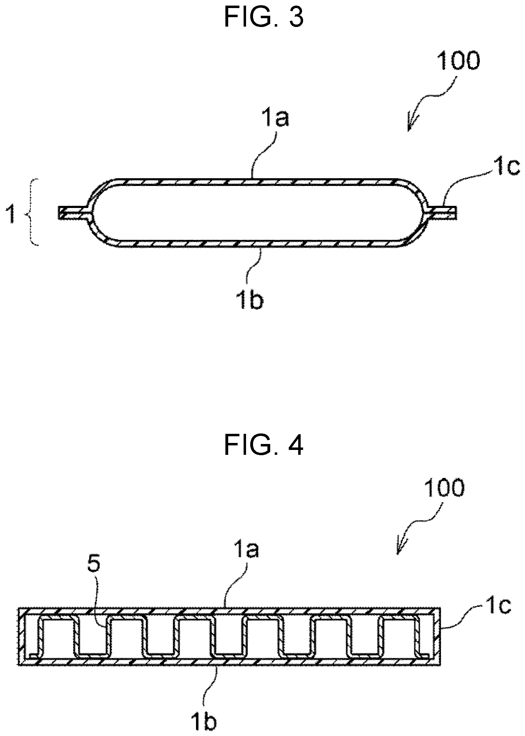

Fig. 3 illustrates a cross-sectional view of a heat exchanger in a modified example of the aspect of Fig. 1. In Fig. 3, a sheet-like material forming the first main surface 1a and a sheet-like material forming the second main surface 1b are overlaid with each other at peripheral edge portions thereof to form the connecting part 1c. In the present aspect, two sheet-like materials are connected at the overlapping portions by, for example, resin fusion, to form a bag-shaped outer covering material.

Fig. 4 illustrates a cross-sectional view of a heat exchanger in a modified example of the aspect of Fig. 1. In Fig. 4, the outer covering material 1 is provided with a corrugated inner core material 5 therein. The inner core material is not integrated with the outer covering material or fixed only to either one of the inner side surface of the first main surface 1a and the inner side surface of the second main surface 1b, whereby the thickness of the heat exchanger 100 can be changed by the inflow of the heat medium.

In the present disclosure, "main surfaces" of the heat exchanger refer to two opposing surfaces having the largest areas among the surfaces (that is, the outer surfaces of the outer covering material) of the heat exchanger formed by the outer covering material. The heat exchanger according to the present disclosure is intended to have a heat exchange target substance arranged on at least one selected from the group consisting of the first main surface and the second main surface. The main surfaces do not necessarily represent flat surfaces, and may be flat surfaces or curved surfaces.

The "connecting part" means a part to which the first main surface and the second main surface are connected. However, the connecting part does not necessarily need to be formed of a material different from the material forming the first main surface and the material forming the second main surface. The connecting part may be a part formed of the material forming the first main surface itself and the material forming the second main surface itself.

The outer covering material is formed in a hollow shape such that the first main surface and the second main surface of the heat exchanger are connected with the connecting part interposed therebetween. The manner of connection is not particularly limited as long as the outer covering material can be formed in a hollow shape. For example, as illustrated in Fig. 2, the first main surface and the second main surface may be connected with a side surface interposed therebetween. As illustrated in Fig. 3, the sheet-like material forming the first main surface and the sheet-like material forming the second main surface may be connected at the peripheral edge portions by resin fusion or the like. A sheet-like material forming the first main surface and a sheet-like material forming the second main surface may be connected with another sheet-like material interposed therebetween. One sheet-like material may be folded in two, and peripheral edge portions other than the folded portion may be connected to each other by resin fusion or the like.

In the present disclosure, in the case of using the term "sheet-like", the thickness and the material thereof are not limited.

In the present disclosure, the "thickness" of the heat exchanger represents a distance between the first main surface and the second main surface. A specific thickness of the heat exchanger in the present disclosure is a distance between a randomly selected point on the second main surface arranged along a flat surface and an intersection of a perpendicular line from the randomly selected point and the first main surface.

A possible thickness of the heat exchanger, for example, a maximum thickness, can be appropriately adjusted according to the desired application. For example, the maximum thickness of the heat exchanger may be from 0.5 mm to 50 mm, from 1.0 mm to 45 mm, or from 5.0 to 40 mm.

A method of making the thickness of the heat exchanger changeable is not particularly limited, and examples thereof include using a material having flexibility instead of a rigid body as the outer covering material. Examples of the method also include not using an inner core material, or in the case of using an inner core material, a method in which the inner core material is not fixed to the outer covering material.

As a technique of changing the thickness of the heat exchanger, while the method of increasing the thickness of the heat exchanger by inflow of a heat medium is simple, any technique that can change the internal pressure of the heat exchanger can be adopted.

Hereinafter, each member and functions thereof of the heat exchanger according to the present disclosure will be described.

### (Outer Covering Material)

The outer covering material is formed in a hollow shape and provided with a heat medium inlet and a heat medium outlet.

The material of the outer covering material is not particularly limited. In one aspect, it is preferable that the outer surface of the outer covering material has an insulating property. In conventional heat exchangers, in some cases, an insulating material having high thermal conductivity is arranged between a heat exchanger and a heat exchange target substance to absorb concave and convex portions of the heat exchange target substance and perform insulation. In the heat exchanger in this aspect, the outer surface of the outer covering material has an insulating property, and therefore, such an insulating material can be omitted. Examples of the material of the outer covering material having an insulating property include resin.

In one aspect, the outer covering material may include a metal layer and a resin layer provided at the inner side of the metal layer. In this aspect, the metal layer and the resin layer may be layered one on another to form a laminate material. The metal layer functions as an electrothermal material, and the resin layer functions as a protective material for the metal layer. In this aspect, the resin layer is provided at the inner side of the metal layer, and therefore, corrosion of the metal layer by the heat medium can be suppressed, and the life of the heat exchanger can be prolonged. Another layer may or need not be provided between the metal layer and the resin layer at the inner side.

In one aspect, the outer covering material may include a metal layer and a resin layer provided at the outer side of the metal layer. This aspect is useful in that, in a case in which an insulating resin is used as the resin, insulation can be achieved even in a case in which a heat exchange target substance is directly arranged adjacent to the resin layer. Therefore, according to this aspect, it is possible to omit separately arranging an insulating material between the heat exchanger and the heat exchange target substance. Further, in a case in which a conductive resin is used as the resin, an antistatic effect can be imparted to the heat exchange target substance. Another layer may or need not be provided between the metal layer and the resin layer on the outer side.

In one aspect, the outer covering material may include a metal layer and a resin layer provided at the inner side and the outer side of the metal layer. In this aspect, a resin layer is provided at both the inner side and the outer side of the metal layer, and therefore, both of the advantages described above can be achieved.

In each aspect described above, the internal space side of the hollow outer covering material is referred to as "inside/inner side", and the outer space side of the hollow outer covering material is referred to as "outside/outer side".

Examples of the metal layer include an aluminum foil, a stainless foil, a nickel foil, a plated copper foil, a clad metal of a nickel foil and a copper foil. From the viewpoint of thermal conductivity, cost, and the like, an aluminum foil is preferable.

The thickness of the metal layer is not particularly limited. From the viewpoint of strength and thermal conductivity, the thickness of the metal layer is preferably 4 µm or more, more preferably 6 µm or more, and still more preferably 8 µm or more. From the viewpoint of thickness reduction, the thickness of the metal layer is preferably 300 µm or less, more preferably 200 µm or less, and still more preferably 100 µm or less. From the foregoing viewpoints, the thickness of the metal layer is preferably from 4 µm to 300 µm, more preferably from 6 µm to 200 µm, and still more preferably from 8 µm to 100 µm. In one aspect, the maximum thickness of the metal layer may be within these ranges in a case in which the thickness of the metal layer varies depending on the site.

The material of the resin layer is not particularly limited. The resin may be a thermoplastic resin or a thermosetting resin. Examples of the resin include a polyolefin-based resin, such as polyethylene or polypropylene (for example, unstretched polypropylene), or a modified resin thereof; a fluorine-based resin; a polyester-based resin such as a polyethylene terephthalate (PET) resin; and a vinyl chloride resin. Since these resins have thermal fusibility, these resins are useful in that the hollow outer covering material can be easily produced by thermal fusion.

The thickness of the resin layer is not particularly limited. From the viewpoint of the insulating property, sufficient protection of the metal layer, adhesion to the heat exchange target substance, and the like, the thickness of the resin layer is preferably 10 µm or more, more preferably 15 µm or more, or still more preferably 20 µm or more. From the viewpoint of thickness reduction, the thickness of the resin layer is preferably 5000 µm or less, more preferably 3000 µm or less, and still more preferably 1000 µm or less. From such viewpoints, the thickness of the resin layer is preferably from 10 µm to 5000 µm, more preferably from 15 µm to 3000 µm, and still more preferably from 20 µm to 1000 µm. In one aspect, the maximum thickness of the resin layer may be within these ranges in a case in which the thickness of the resin layer varies depending on the site.

In a case in which a resin layer is provided at both the inner side and the outer side of the metal layer, the thickness of the resin layer described above represents the thickness of each resin layer.

In one aspect, in a case in which a resin layer is provided at both the inner side and the outer side of the metal layer, the thickness of the resin layer at the inner side may be equal to or larger than the thickness of the resin layer at the outer side from the viewpoint of sufficient protection of the metal layer.

In a case in which the outer covering material includes a metal layer and a resin layer provided at at least one selected from the group consisting of the inner side and the outer side of the metal layer, the metal layer and each resin layer may be bonded with each other by, for example, an adhesive agent. The metal layer and each resin layer may be layered one on another by a known lamination method.

The thickness of the outer covering material can be designed according to the material, a desired function, and the like of the outer covering material. For example, the thickness of the outer covering material may be from 4 µm to 15,000 µm, from 10 µm to 10,000 µm, or from 30 µm to 5,000 µm. In one aspect, the maximum thickness of the outer covering material may be within these ranges in a case in which the thickness of the outer covering material varies depending on the site.

The positions of the heat medium inlet and the heat medium outlet are not particularly limited as long as the heat exchange of the heat exchange target substance arranged at the heat exchanger is possible by a heat medium flowing in from the heat medium inlet and flowing out from the heat medium outlet. In one aspect, the heat medium inlet and the heat medium outlet may be respectively provided at opposite ends of the heat exchanger from each other.

### (Inner Core Material)

In one aspect, the heat exchanger may further include an inner core material arranged inside the outer covering material. The inner core material can be used for maintaining the shape of the heat exchanger, improving heat exchange efficiency, and the like.

In one aspect, it is preferable that the inner core material is fixed to only one of the inner side surface of the first main surface or the inner side surface of the second main surface of the outer covering material, or to neither the inner side surface of the first main surface nor the inner side surface of the second main surface. This allows the heat exchanger to increase its thickness by circulating a heat medium while maintaining a desired shape thereof. The inner core material may be integrally formed with the outer covering material by deep drawing or the like.

The material of the inner core material are not particularly limited, and examples thereof include a metal and a resin. Specific examples of the metal and the resin include the materials listed as examples of the materials of the metal layer and the resin layer of the outer covering material.

In one aspect, the inner core material may be a metal layer coated with a resin. In a case in which the inner core material is a metal layer coated with resin, another layer may or need not be provided between the metal layer and the resin.

In one aspect, the inner core material may have concave and convex portions. For example, the inner core material may be formed in a corrugated plate shape by corrugation processing or pleating, or may be provided with concave and convex portions by embossing. The inner core material may be provided with only concave portions or only convex portions.

The shapes of the concave and convex portions are not particularly limited, and may be a circular shape, an elliptical shape, an oval shape, a polygonal shape such as a triangle, a quadrangle, or a pentagon, an irregular shape, or any combination thereof, for example. The inner core material may have a diamond pattern, a silk pattern, a cloth pattern, a satin pattern, a polka dot pattern, a reed screen pattern, a streak pattern, or the like.

The pattern of plural concave and convex portions is not particularly limited, and the concave and convex portions may be arranged regularly or irregularly.

The depth of the concave portion or the height of the convex portion of the inner core material are not particularly limited, and may be 0.1 mm or more, 5 mm or more, or 10 mm or more, from the viewpoint of sufficiently securing a path for circulating a heat medium. From the viewpoint of thickness reduction, the depth of the concave portion or the height of the convex portion of the inner core material may be 50 mm or less, 40 mm or less, or 30 mm or less. From the foregoing viewpoints, the depth of the concave portion or the height of the convex portion of the inner core material may be from 0.1 mm to 50 mm, from 5 mm to 40 mm, or from 10 mm to 30 mm.

In the present disclosure, the depth of the concave portion of the inner core material is a depth from the middle position to the deepest portion of the inner core material in the thickness direction, and the height of the convex portion is a height from the middle position to the uppermost portion of the inner core material in the thickness direction. A dimension obtained by adding the depth of the concave portion and the height of the convex portion corresponds to the thickness of the inner core material.

In one aspect, the maximum value of the depth of the concave portion of the inner core material or the maximum value of the height of the convex portion of the inner core material may be within the foregoing ranges in a case in which the thickness of the inner core material varies depending on the site.

In one aspect, the inner core material may be an inner core material that is similar to the inner core material described in JP-A No. 2020-3132, but that is fixed to the outer covering material only on one of the inner side surface of the first main surface or the inner side surface of the second main surface, or that is not fixed to the outer covering material on the inner side surface of the first main surface or the inner side surface of the second main surface. In other words, the inner core material may be one that is formed of an inner core laminate material including an electrothermal layer made of metal and thermal fusion layers made of resin provided at both sides of the electrothermal layer, that have concave and convex portions, and that is fixed to the outer covering material only on one side or on neither side.

### (Other Structures)

The heat exchanger may include structures other than the outer covering material and the inner core material.

In one aspect, the heat exchanger may be configured such that each of the heat medium inlet and the heat medium outlet is provided with a joint pipe, and a heat medium flows into and out of the outer covering material through the joint pipes. The material of the joint pipe is not particularly limited. In one aspect, the joint pipe may include a resin layer that is fused to the outer covering material including a resin layer. By fusing the joint pipe and the outer covering material, liquid leakage can be easily prevented.

### [Application of Heat Exchanger]

The application of the heat exchanger according to the present disclosure is not particularly limited. The heat exchanger is applicable as a cooling device or a heating device in various applications in which heat exchange is desired. Therefore, the heat medium may be a cooling medium or a heating medium.

### <Structural Body>

A structural body according to the present disclosure includes the heat exchanger according to the present disclosure described above and a heat exchange target substance provided at the heat exchanger.

Examples of the heat exchange target substance include a heating element, such as a semiconductor package, a display, an LED, an electric lamp, an automobile power module, or an industrial power module. The heat exchanger may be utilized as a heating device used for floor heating, snow removal, or the like. In one aspect, the heat exchanger may be incorporated into a converter case in a power control unit of a vehicle, and may be used for cooling a reactor, a DC/DC converter, and the like.

A heat exchange target substance may be provided at both or only one of the first main surface side and the second main surface side of the heat exchanger. In a case in which a heat exchange target substance is provided at only one of the first main surface side and the second main surface side of the heat exchanger, another member such as a substrate may be arranged on the other main surface, whereby when a heat medium flows into the outer covering material, the heat exchanger can adhere to the heat exchange target substance more closely owing to the internal pressure.

Hereinafter, an example of a converter case in a power control unit of a vehicle, in which the heat exchanger according to the present disclosure is used as a cooling device, will be described with reference to the drawings. However, the structural body according to the present disclosure is not limited to the example illustrated in the drawings.

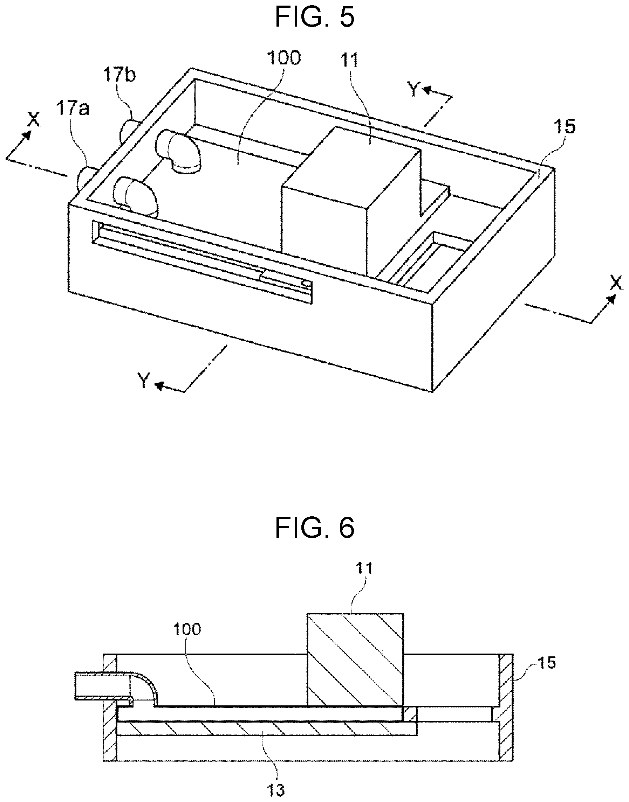

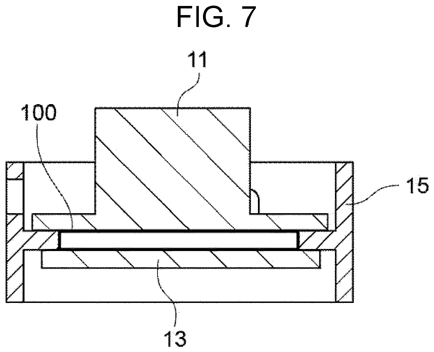

Fig. 5 is a schematic perspective view of a case in which the heat exchanger 100 is applied to a converter case 15. Fig. 6 is a cross-sectional view of the converter case 15 taken along line X-X, and Fig. 7 is a cross-sectional view of the converter case 15 taken along line Y-Y The heat exchanger 100 is connected in the converter case 15. A reactor 11, which is a heat exchange target substance, is arranged at the heat exchanger 100, and a DC/DC converter 13, which is a heat exchange target substance, is arranged below the heat exchanger 100. In the present example, the heat exchanger 100 is provided with a joint pipe 17a connected to a heat medium inlet and a joint pipe 17b connected to a heat medium outlet. By a cooling medium flowing from the joint pipe 17a into the heat exchanger sandwiched between the reactor 11 and the converter 13 and circulating therethrough, stress is applied in directions that increase the thickness of the heat exchanger owing to the internal pressure of the heat exchanger. Therefore, adhesion between the heat exchanger 100 and the reactor 11 and the DC/DC converter 13 is improved.

### <Method of Producing Structural Body>

A method of producing a structural body according to the present disclosure includes arranging a heat exchange target substance at the heat exchanger according to the present disclosure described above. Details of the heat exchanger, the heat exchange target substance, and the structural body are as described above.

The disclosure of Japanese Patent Application No. 2021-083877 is incorporated in the present specification by reference in its entirety. All the documents, patent applications, and technical standards described in the specification are incorporated in the specification by reference to the same extent as the case in which each individual document, patent application, or technical standard is specifically and individually indicated to be incorporated by reference. Reference Signs List

- 1: outer covering material
- 1a: first main surface
- 1b: second main surface
- 1c: connecting part
- 3a: joint pipe
- 3b: joint pipe
- 5: inner core material
- 11: reactor
- 13: DC/DC converter
- 15: converter case
- 17a: joint pipe
- 17b: joint pipe
- 100: heat exchanger

## Claims

1. A heat exchanger comprising a hollow outer covering material provided with a heat medium inlet and a heat medium outlet,
the heat exchanger comprising a first main surface, a second main surface at an opposite side from the first main surface, and a connecting part connecting the first main surface and the second main surface, the first main surface, the second main surface and the connecting part being formed by the outer covering material,
wherein the heat exchanger is configured such that a thickness of the heat exchanger is changeable in response to inflow of a heat medium into the outer covering material.

2. The heat exchanger according to claim 1, wherein the outer covering material includes a metal layer and a resin layer provided at an inner side of the metal layer.

3. The heat exchanger according to claim 1 or 2, wherein the outer covering material includes a metal layer and a resin layer provided at an outer side of the metal layer.

4. The heat exchanger according to any one of claims 1 to 3, wherein the outer covering material includes a metal layer and a resin layer provided at an outer side and an inner side of the metal layer.

5. The heat exchanger according to any one of claims 1 to 4, further comprising an inner core material arranged inside the outer covering material.

6. The heat exchanger according to claim 5, wherein the inner core material is fixed to only one of an inner side surface of the first main surface or an inner side surface of the second main surface of the outer covering material, or to neither the inner side surface of the first main surface nor the inner side surface of the second main surface.

7. A structural body comprising the heat exchanger according to any one of claims 1 to 6 and a heat exchange target substance provided at the heat exchanger.

8. A method of producing a structural body comprising arranging a heat exchange target substance at the heat exchanger according to any one of claims 1 to 6.
